# FASCICULE DE BREVET EUROPEEN

(11) **EP 1 788 110 B1**
(45) Date de publication et mention de la délivrance du brevet: **11.07.2012**
(21) Numéro de dépôt: 06354036.3
(22) Date de dépôt: 08.11.2006
(51) Int. Cl.: C23C 14/16, C23C 14/00, C23C 14/06, C23C 14/14

(54) **Revêtement à base d'argent résistant à la sulfuration, procédé de dépôt et utilisation.**
Anlaufbeständige Silberbeschichtung, Abscheidungsverfahren und Verwendung.
Tarnish-resistant silver coating, process for depositing and use.

(30) Priorité: 18.11.2005 FR 0511708
(43) Date de publication de la demande: 23.05.2007
(73) Titulaire: Commissariat à l'Énergie Atomique et aux Énergies Alternatives, 75015 Paris (FR)
(72) Inventeur: Camel, Denis, 38100 Grenoble (FR); Bedel, Laurent, 38950 Quaix en Chartreuse (FR); Sanchette, Frédéric, 38620 Montferrat (FR); Ducros, Cédric, 38690 Bevenais (FR)
(74) Mandataire: Hecké, Gérard

(56) Documents cités:
- EP-A- 0 679 729
- WO-A-95/13704
- US-A- 5 630 886

## Description

### Domaine technique de l'invention

L'invention concerne un revêtement en matériau à base d'argent comportant un empilement d'une couche principale et d'un film mince oxydé.

L'invention concerne également un procédé de dépôt d'un tel revêtement et une utilisation d'un tel dépôt.

### État de la technique

Les matériaux à base d'argent sont connus pour s'oxyder naturellement à l'air ambiant. Une fine couche d'oxyde se forme alors à la surface des objets à base d'argent. Son épaisseur est de l'ordre de quelques nanomètres.

Par ailleurs, ils sont connus pour ternir lorsqu'ils sont mis en contact avec de l'air pollué par des traces de composés à base de soufre. En effet, l'argent réagit avec le soufre ou l'acide sulfhydrique et cette réaction provoque la formation d'une couche de corrosion de couleur noire, rendant la surface des objets à base d'argent terne. C'est notamment le cas des bijoux ou des objets d'argenterie. Pour éliminer ce ternissement, il faut appliquer des laques ou réaliser des opérations d'entretien répétées. De plus, ce phénomène de ternissement entraîne une augmentation de la résistance électrique de contact du matériau ou de l'objet à base d'argent. L'augmentation de cette caractéristique freine, ainsi, l'utilisation des alliages à base d'argent dans le domaine de la connectique, et notamment pour les faibles courants. Enfin, le phénomène de ternissement ne permet pas d'exploiter les propriétés oligodynamiques de l'argent, dans des applications de protection antibactérienne lors de contact avec de l'air pollué. En effet, contrairement à l'argent pur, le sulfure d'argent qui se forme à la surface d'un objet à base d'argent ne présente pas d'activité antibactérienne, du fait de sa faible solubilité dans l'eau.

De nombreuses recherches ont été réalisées pour améliorer la résistance à la sulfuration ou la résistance au ternissement des matériaux à base d'argent. Elles concernent principalement deux voies.

La première voie consiste à recouvrir, par dépôt physique ou électrochimique, la surface des objets à base d'argent, d'une couche de protection qui peut être métallique, oxyde ou organique. À titre d'exemple, les couches de protection métalliques utilisées sont des couches en or, en palladium, en platine ou en rhodium, avec une épaisseur de l'ordre de 10 à 20nm. Les couches de protection en oxyde sont, par exemple, en alumine, en zircone, en oxyde de titane ou d'étain. Cependant, l'utilisation d'une couche de protection pour améliorer la résistance à la sulfuration n'est pas satisfaisante dans la mesure où elle altère souvent les propriétés superficielles de l'objet, telles que la couleur, la réflectivité, la résistance au contact électrique. De plus, la barrière de protection qu'elle forme n'est pas totalement fiable et elle est peu durable. En effet, elle est sensible aux défauts du revêtement et à l'usure.

La seconde voie consiste à allier l'argent avec des éléments d'addition métalliques. À titre d'exemple, dans l'article « Silver, silver compounds and silver alloys » (Ullmann's Encyclopedia of Industrial Chemistry, 1993 VCH Publishers, Inc, Vol. A24, pages 148-149), H. Renner décrit le phénomène de ternissement de l'argent et indique que l'incorporation d'or, de platine ou de palladium dans l'alliage améliore la résistance au ternissement. Cependant, les alliages à base d'argent et de métaux nobles n'offrent une amélioration de la résistance à la sulfuration que pour des teneurs d'alliage élevées. En effet, les métaux nobles ne migrent pas naturellement à la surface de l'argent.

Pour réduire l'effet de ternissement, l'argent peut également être allié à un ou plusieurs éléments d'addition, métalliques et oxydables, tels que le germanium ou l'étain. Le brevet US6,168,071 mentionne, par exemple, l'addition d'une petite quantité de germanium dans un alliage à base d'argent et de cuivre pour réduire l'effet de ternissement. L'alliage comporte, ainsi, au moins 77% en poids d'argent, de 0,4% à 7% en poids de germanium, le reste étant principalement du cuivre et du bore. Les éléments d'addition métalliques et oxydables permettent, en effet, de former par ségrégation, un film protecteur d'oxyde natif à la surface du matériau à base d'argent. Cependant, ce film protecteur n'est pas suffisamment efficace pour arrêter le phénomène de sulfuration. En effet, le film reste très fin, avec une épaisseur inférieure à 10nm et ne peut se régénérer que très lentement par diffusion du ou des solutés contenus dans la matrice argentique vers la surface libre. De plus, lorsque les alliages sont élaborés par coulée, leur comportement est sensible aux micro-ségrégations issues de l'étape de solidification. Ainsi, il peut se produire des variations de composition dans la solution solide et surtout une précipitation des phases intermétalliques formées entre les différents constituants, rendant la formation du film d'oxyde natif aléatoire.

Le magnésium est également connu pour protéger un matériau à base d'argent. Le brevet US 5,630,886 propose, par exemple, une structure composite utilisable comme film réfléchissant et comportant un substrat en argent ou à base d'argent et un film de protection en alliage de magnésium et d'argent (Ag-Mg) évitant au substrat d'être corrodé par l'ozone et les composants sulfurés. Le film de protection peut subir une oxydation native ou une oxydation provoquée. Une telle oxydation provoque la formation d'une couche mince en oxyde de magnésium (MgO) dans le film de protection et une migration du magnésium dans la couche oxydée. La structure composite ainsi obtenue comporte alors un substrat à base d'argent recouvert d'un film de protection comportant une couche ayant une composition proche de celle de l'argent pur et une couche en MgO. De plus, une couche de protection en résine peut être rajoutée. Le film de protection présente, alors, les mêmes inconvénients que les couches de protection en oxyde, mentionnées ci-dessus.

### Objet de l'invention

L'invention a pour but un revêtement en matériau à base d'argent, comportant un empilement d'une couche principale et d'un film mince oxydé et offrant une résistance à la sulfuration fortement améliorée par rapport aux revêtements selon l'art antérieur.

Plus particulièrement, l'invention a pour but un revêtement offrant une résistance à la sulfuration fortement améliorée, tout en préservant les propriétés du matériau à base d'argent, telles que ses propriétés optiques, électriques ou antibactériennes.

Selon l'invention, ce but est atteint par les revendications annexées. Plus particulièrement, ce but est atteint par le fait que le film mince oxydé a une épaisseur comprise entre 10nm et 1µm et par le fait qu'il présente un gradient de concentration en argent décroissant depuis l'interface entre le film mince et la couche principale jusqu'à la surface libre du film mince.

L'invention a également pour but un procédé de dépôt permettant d'obtenir un revêtement en matériau à base d'argent ayant une résistance à la sulfuration améliorée par rapport aux revêtements selon l'art antérieur.

Selon l'invention, ce but est atteint par le fait que le procédé comporte au moins deux étapes successives de dépôt physique en phase vapeur, respectivement de la couche principale et du film mince oxydé.

L'invention a également pour objet une utilisation d'un tel revêtement sur un objet de joaillerie, dans un dispositif antibactérien ou dans un dispositif de connexion.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente un mode particulier d'un revêtement selon l'invention.
La figure 2 est une représentation schématique d'un mode particulier d'évolution des concentrations en argent ([Ag]) et en oxygène ([O]) dans un revêtement selon l'invention.
Les figures 3 et 4 représentent la variation de la concentration en oxygène et en silicium dans un revêtement selon l'invention, disposé sur un support en silicium, en fonction du temps de décapage ionique utilisé lors d'un essai de mesure à la sonde ionique, de l'oxygène ayant été introduit à la fin du procédé de dépôt, avec respectivement un débit de 10 sccm et de 25 sccm.
La figure 5 représente la variation de couleur Δ(L, a, b) observée sur des revêtements de type C0 à C3 en matériau à base d'argent, déposés sur un support selon différents modes de dépôt et respectivement soumis à un test de sulfuration.
La figure 6 représente l'évolution de la variation de couleur observée sur un revêtement de type C2, soumis à un test de sulfuration, en fonction de l'épaisseur du film mince oxydé dudit revêtement.
La figure 7 illustre l'activité antibactérienne de différents échantillons revêtus par un revêtement en matériau à base d'argent, par rapport à des échantillons non revêtus.

### Description de modes particuliers de réalisation

La résistance à la sulfuration d'un revêtement en matériau à base d'argent est améliorée de manière accrue en réalisant, depuis la surface libre du revêtement jusqu'à une profondeur comprise entre 10nm et 1µm et plus particulièrement entre 100nm et 1µm, un gradient de concentration en argent, en oxygène et éventuellement en un ou plusieurs éléments d'addition (ou solutés) oxydables présents dans le matériau.

Par gradient de concentration en un élément chimique, on entend une variation continue de la concentration en ce dit élément chimique depuis la surface libre jusqu'à une profondeur comprise entre 10nm et 1µm.

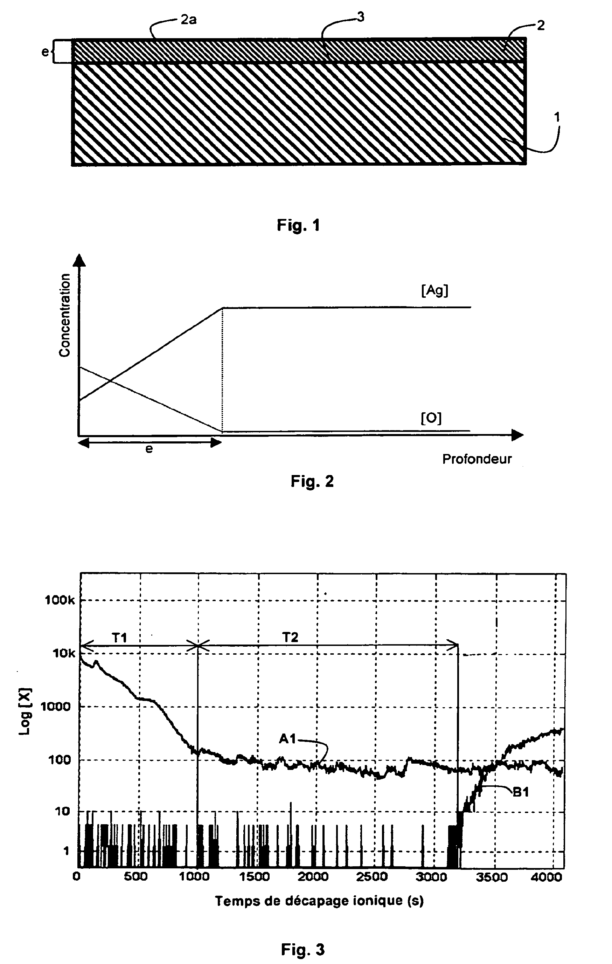

Ainsi, comme représenté sur la figure 1, un revêtement en matériau à base d'argent selon l'invention comporte un empilement d'une couche principale 1 et un film mince oxydé 2.

La couche principale 1 peut être une couche mince en argent ou en alliage à base d'argent. Plus particulièrement, la couche principale 1 est formée par un alliage comportant, outre de l'argent, au moins un élément d'addition métallique oxydable. Le choix du ou des éléments d'addition est, de préférence, dicté par des critères relatifs à leur capacité à former, en surface, un oxyde capable de rendre l'alliage résistant à la sulfuration. Ainsi, le ou les éléments d'addition sont, plus particulièrement choisis, en fonction de leur solubilité dans l'argent solide, de leur tendance à migrer en surface et de la stabilité de l'oxyde qu'ils forment. Plus particulièrement, le ou les éléments d'addition sont, de préférence, prioritairement choisis parmi l'étain, l'indium, le zinc et le germanium, et en second lieu parmi l'aluminium, le magnésium, le manganèse et le titane. De plus, le choix du ou des éléments d'addition peut également être influencé par l'application dans laquelle le revêtement est utilisé. Ainsi, un élément d'addition peut également être choisi en fonction de son apport pour améliorer les propriétés mécaniques (par exemple la résistance à l'usure), optiques (par exemple la réflectivité) et/ou électriques (par exemple la résistance électrique de contact) de l'alliage.

Le film mince oxydé 2 comporte au moins le ou les éléments chimiques constituant la couche principale 1 et de l'oxygène. Le film mince oxydé 2 a une épaisseur e comprise entre 10nm et 1µm et, plus particulièrement, entre 100nm et 1µm. De plus, il présente un gradient de concentration en argent décroissant depuis l'interface 3 entre le film mince 2 et la couche principale 1 jusqu'à la surface libre 2a du film mince 2. L'oxygène contenu dans le film mince 2 est apporté, volontairement et de manière contrôlée, pendant le procédé de fabrication ou de dépôt du revêtement. Le film mince 2 comporte un gradient de concentration en oxygène croissant, c'est-à-dire une variation continue croissante en oxygène, depuis l'interface 3 entre le film mince 2 et la couche principale 1 jusqu'à la surface libre 2a du film mince 2. À titre d'exemple, sur la figure 2 représentant schématiquement un profil particulier de la concentration en argent ([Ag]) et en oxygène ([O]) dans un revêtement selon l'invention, la variation de la concentration en argent et en oxygène est linéaire dans le film mince 2. Par contre, dans la couche principale 1, la concentration en argent ([Ag]) et en oxygène ([O]) est sensiblement constante.

De plus, si le matériau à base d'argent est un alliage comprenant au moins un élément d'addition oxydable, le film mince 2 présente alors, également, un gradient de concentration en élément d'addition croissant, depuis l'interface 3 entre le film mince 2 et la couche principale 1 jusqu'à la surface libre 2a du film mince 2.

Un tel film mince oxydé présente alors l'avantage de passer de manière progressive et continue d'une composition correspondant à un oxyde passivant présent à la surface libre 2a du film mince oxydé 2 vers une composition présente à l'interface 3 du film mince oxydé 2 et de la couche principale 1 et correspondant à une solution solide d'argent, riche en élément d'addition oxydable. Ceci permet au film mince oxydé 2 de former une barrière protectrice contre la sulfuration, beaucoup plus efficace et plus durable que les voies envisagées dans l'état de la technique. Par ailleurs, le film mince oxydé ne détériore pas les propriétés du matériau à base d'argent, telles que ses propriétés optiques, électriques ou antibactériennes.

Un revêtement selon l'invention peut être déposé sur tout type de pièce ou de support, au moyen de techniques de dépôt telles qu'un procédé de dépôt sous vide.

Selon un mode particulier de réalisation, le revêtement est déposé sur un support ou substrat en deux étapes successives de dépôt physique en phase vapeur (PVD), de manière à former successivement la couche principale 1 et le film mince oxydé 2.

Plus particulièrement, les deux étapes de dépôt sont des étapes de dépôt par pulvérisation cathodique magnétron, réalisée dans une enceinte de dépôt, à partir d'une cible ou cathode constituée d'un alliage à base d'argent et d'au moins un élément d'addition. Les deux étapes de dépôt sont, de préférence, réalisées avec polarisation négative du support. Par polarisation négative du support, on entend que le support destiné à recevoir le revêtement est soumis à un potentiel électrique de polarisation, négatif par rapport à la masse. Ainsi, le support est, par exemple, soumis à un premier potentiel de polarisation constant et négatif, pendant la première étape de dépôt, puis à un second potentiel de polarisation, négatif, constant et inférieur au premier potentiel, pendant la seconde étape de dépôt. Le premier potentiel de polarisation est, par exemple, de l'ordre de -130V tandis que le second potentiel de polarisation est, par exemple, de l'ordre de -300V. Ce changement de polarisation entre les deux étapes du procédé de dépôt permet, ainsi, de réaliser le gradient de concentration en argent dans le film mince 2. En effet, le taux de re-pulvérisation de l'argent à la surface de la couche principale 1 préalablement formée est plus élevé que celui des éléments d'addition, il en résulte un enrichissement superficiel du film mince 2 en élément d'addition, ce qui provoque la création du gradient de concentration en argent et en élément d'addition.

Par ailleurs, l'oxydation du film mince 2 est provoquée par l'introduction d'oxygène dans le plasma lors de l'étape de dépôt du film mince. Cette introduction d'oxygène dans le plasma permet de réaliser un enrichissement progressif en oxygène dans le film mince 2 et donc de créer un gradient de concentration en oxygène croissant, depuis l'interface 3 jusqu'à la surface libre 2a du film mince 2. Le degré d'enrichissement en oxygène peut être contrôlé par la valeur du potentiel de polarisation appliquée au support et/ou par la valeur du flux d'oxygène introduit dans le plasma. Par ailleurs, l'épaisseur du film mince dépend de la durée de la seconde étape de dépôt.

À titre d'exemple, un revêtement d'un alliage ternaire à base d'argent et comportant 4% en poids de germanium et 8% en poids d'étain (alliage noté AgGeSn) a été déposé sur un substrat ou anode en silicium par pulvérisation cathodique magnétron, au moyen d'une cible réalisée en alliage AgGeSn. La distance entre la cible et le support sur lequel est déposé le revêtement est de 80mm et les autres conditions de dépôt utilisées pendant les différentes étapes du dépôt du revêtement, sont indiquées dans le tableau ci-dessous :

| **Étape** | **Pression en Argon (Pa)** | **Débit de gaz injecté dans l'enceinte (sccm)** | **Puissance de la cible (W)** | **Potentiel de polarisation du substrat (V)** |
|---|---|---|---|---|
| 1) Mise sous vide de l'enceinte de dépôt | 8.10⁻⁴ | - | - | - |
| 2) Décapage de la cible (avec cache) | 0,5 | Ar : 145 | 100 | - |
| 3) Dépôt de la couche principale 1 | 0,5 | Ar : 145 | 300 | -130 |
| 4) Dépôt du film mince oxydé 2 | 0,5 | Ar : 145 O₂ : 10 à 60 | 300 | -300 |

La durée de l'étape de décapage de la cible est de l'ordre de 5 à 10 minutes et la durée des étapes de dépôt de la couche principale 1 et du film mince 2 est en fonction de l'épaisseur désirée pour chacun.

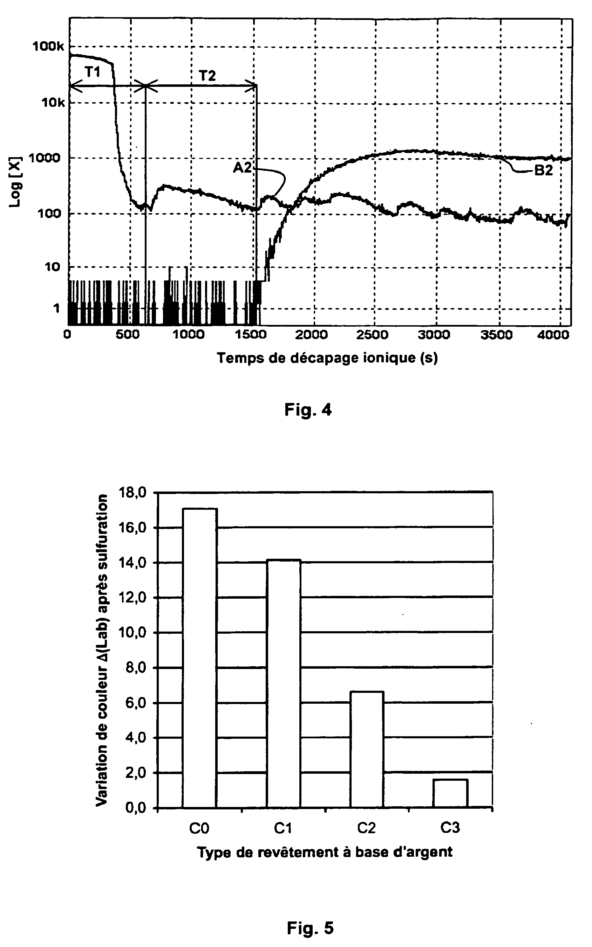

Par ailleurs, le profil de concentration d'un tel revêtement peut être mis en évidence par mesure à la sonde ionique. Ainsi, à titre d'exemple, les figures 3 et 4 représentent l'évolution relative des concentrations en oxygène et en silicium, en fonction du temps de décapage ionique d'un revêtement en alliage AgGeSn de 3µm d'épaisseur, respectivement pour une introduction dans le plasma de 10 centimètres cubes standards par minute (noté sccm ou « standard centimeter cube per minute ») et de 25 sccm d'oxygène. Le temps de décapage ionique est fonction de la profondeur du revêtement depuis la surface libre 2a du film mince 2 jusqu'au substrat en silicium. Les substrats en silicium utilisés dans les deux cas sont d'épaisseurs distinctes.

Sur les figures 3 et 4, les deux courbes correspondant à l'évolution de concentration en oxygène sont respectivement notées A1 et A2 tandis que celles correspondant à l'évolution de concentration en silicium sont respectivement notées B1 et B2. Le suivi de l'élément silicium par mesure à la sonde ionique permet, ainsi, de déterminer l'instant où le substrat en silicium est atteint par le faisceau d'ions primaires utilisé pour décaper le support en silicium muni d'un revêtement selon l'invention. Le suivi de l'élément oxygène permet de déterminer l'instant où est atteinte la couche principale 1 du revêtement.

Ainsi, sur la figure 3, on constate que le substrat en silicium est atteint par décapage, après environ 3250 secondes tandis que, sur la figure 4, le substrat en silicium est atteint après environ 1500 secondes. De plus, on observe que, pour un débit de 10 sccm d'oxygène, la concentration en oxygène diminue progressivement en fonction du temps de décapage, pendant une première période de temps T1, puis elle se stabilise. Ainsi, la première période de temps T1 correspond au décapage du film mince 2 et la diminution progressive en oxygène illustre le gradient de concentration en oxygène, dans le film mince 2, décroissant depuis la surface libre 2a du film mince 2 (temps de décapage égal à 0) jusqu'à l'interface 3 entre le film mince 2 et la couche principale 1. Ladite interface 3 correspond en effet à la fin de la première période de temps T1, c'est-à-dire à un temps de décapage ionique de l'ordre de 1000 secondes. Par ailleurs, la période de temps T1 est suivie d'une seconde période de temps T2 correspondant à une période de temps pendant laquelle la concentration en oxygène est quasi-constante et la concentration en silicium est encore quasi-nulle. Ainsi, cette seconde période de temps T2 correspond au décapage de la couche principale 1 du revêtement.

Sur la figure 4, l'évolution de la concentration en oxygène diffère de celle de la figure 3. En effet, la teneur en oxygène est dix fois plus élevée près de la surface libre 2a du film mince 2 que dans le premier cas et elle diminue très rapidement. Dans ce cas, la variation de la concentration en oxygène n'est pas une variation progressive. De plus, la forte concentration en oxygène, à la surface libre du revêtement provoque une modification des propriétés du revêtement, en augmentant notamment sa résistivité électrique et donc en diminuant sa réflectivité. Ainsi, le revêtement formé avec un débit en oxygène de 10 sccm est plus adapté que celui formé avec un débit en oxygène de 25 sccm.

La résistance à la sulfuration d'un revêtement selon l'invention peut être évaluée en mesurant par spectrophotométrie la variation de couleur du revêtement, lorsqu'il est exposé aux vapeurs d'une solution aqueuse de sulfure d'ammonium. Ainsi, à titre d'exemple, un bécher de 50mm de diamètre et de 70mm de hauteur, contenant 1ml de sulfure d'ammonium à 4% et 20ml d'eau distillée, est placé dans un dessiccateur ayant un volume de 5l. Un panier en plastique dans lequel reposent, à plat, plusieurs revêtements en AgGeSn est placé dans le dessiccateur, à une hauteur prédéterminée, pendant une heure. Puis, l'avancée de la sulfuration est mesurée par un spectrophotomètre, permettant de quantifier une teinte à partir de trois valeurs L, a et b, correspondant respectivement :
- à la luminance exprimée en pourcentage : de L = 0% pour le noir à L = 100% pour le blanc
- à une gamme de couleur allant du vert (a = -120) au rouge (a = 120)
- à une gamme de couleur allant du bleu (b = -120) au jaune (b = 120).

Ainsi, il est possible de déterminer par spectrophotométrie une variation de couleur, notée Δ(L, a, b) et correspondant à ((ΔL)² + (Δa)² + (Δb)²)^{0,5}.

Des essais de sulfuration ont été réalisés :
- pour des revêtements en AgGeSn obtenus par pulvérisation cathodique magnétron, sur un substrat polarisé à un potentiel constant de -130V et sans introduction d'oxygène pendant le procédé de dépôt, de tels revêtements sont dits revêtements de type C1,
- pour des revêtements en AgGeSn selon un premier mode de réalisation de l'invention, appelés revêtements de type C2 et obtenus par pulvérisation cathodique magnétron, sur un substrat polarisé, à un potentiel constant de -130V et avec une introduction d'un débit d'oxygène de 10 sccm pendant la seconde étape de dépôt,
- pour des revêtements en AgGeSn selon un second mode de réalisation de l'invention, appelés revêtements de type C3 et obtenus par pulvérisation cathodique magnétron, sur un substrat polarisé à un premier potentiel constant de -130V pendant la première étape de dépôt, puis à un second potentiel constant de -300V pendant la seconde étape de dépôt et avec une introduction d'un débit d'oxygène de 10 sccm pendant la seconde étape de dépôt.

Ainsi, la figure 5 représente les valeurs moyennes de la variation de couleur Δ(L, a, b) pour les revêtements de type C1 à C3 et pour un revêtement de type C0 obtenu par dépôt électrolytique, après un essai de sulfuration. On observe, ainsi, que les revêtements de type C2 et C3 présentent des valeurs moyennes de variation de couleur inférieures à celles des revêtements de type C0 et C1. Ainsi, la résistance à la sulfuration est améliorée lorsque les revêtements sont réalisés en modifiant la polarisation du substrat entre les deux étapes du procédé de dépôt et/ou en introduisant de l'oxygène dans l'enceinte de dépôt, pendant la deuxième étape de dépôt. De plus, la valeur moyenne de la variation de couleur des revêtements de type C3 est plus faible que celle des revêtements de type C2. Ainsi, la résistance à la sulfuration est d'autant améliorée lorsque la polarisation du substrat est modifiée au début de la deuxième étape de dépôt et lorsque de l'oxygène est introduit dans l'enceinte de dépôt, pendant la deuxième étape de dépôt.

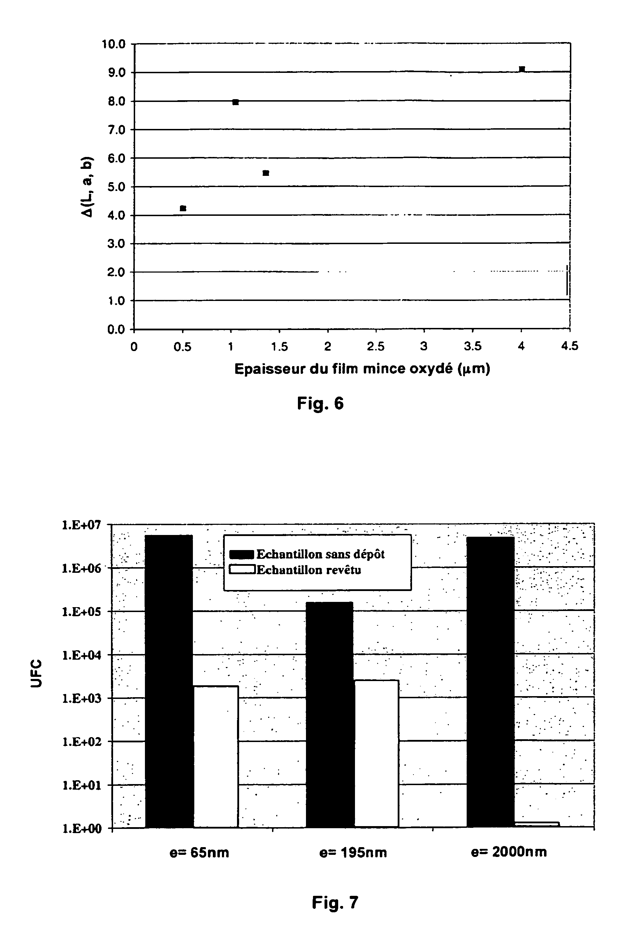

La figure 6 représente, après un test de sulfuration, l'évolution de la variation de couleur Δ(L, a, b), pour des films minces oxydés 2 de revêtements de type C2, les films minces oxydés 2 ayant respectivement des épaisseurs de l'ordre de 0,5µm, 1,1µm, 1,4µm et 4µm. On constate, ainsi, que le film mince oxydé dont l'épaisseur est de l'ordre de 0,5µm présente une résistance à la sulfuration plus grande que les autres films minces oxydés.

La résistance à la sulfuration est donc améliorée lorsque le revêtement comporte sur une épaisseur comprise entre 10nm et 1µm, des gradients de concentration en argent et en oxygène, respectivement décroissant et croissant, depuis l'interface 3 jusqu'à la surface libre 2a.

Un revêtement selon l'invention présente également l'avantage d'avoir une activité antibactérienne. À titre d'exemple, comme représenté sur la figure 7, un essai antibactérien a été réalisé sur trois types de revêtements en AgGeSn, ayant respectivement des épaisseurs de 65nm, 195nm et 2µm. L'essai antibactérien consiste à déposer sur deux lames de verre de même épaisseur, une suspension bactérienne standardisée de staphyloccocus aureus, une des deux lames comportant un revêtement selon l'invention (notée « échantillon revêtu » sur la figure 7) et l'autre étant nue, c'est-à-dire sans revêtement (notée « échantillon sans dépôt » sur la figure 7). L'ensemble des lames de verre est, ensuite, recouverte par un film plastique stérile. Elles sont, ensuite, placées dans un incubateur humide, à 37°C, pendant 18 heures. Enfin, chaque lame est trempée dans une solution permettant de récupérer et de dénombrer les bactéries restantes. L'unité de mesure du nombre de bactéries est l'abréviation UFC correspondant à l'Unité Formant une Colonie ou, en anglais CFU pour « Colony Forming Unit ». Ainsi, une UFC correspond à une colonie observée, mais elle peut, également correspondre à plusieurs cellules si elles restent agrégées lors du dénombrement. On constate, ainsi, sur la figure 7, qu'en comparaison à l'échantillon sans dépôt correspondant, chaque revêtement a un effet bactéricide. L'effet bactéricide est partiel pour les revêtements de 65nm et de 195 nm tandis qu'il est quasi-total pour le revêtement de 2µm d'épaisseur totale.

Dans un autre exemple de réalisation, un revêtement de 185nm d'épaisseur est réalisé sur un substrat en silicium plan, avec une pression en argon de 0,5 Pa, un débit de gaz en argon de 140 sccm et avec une introduction d'oxygène, lors de la seconde étape de dépôt, selon un débit de 30 sccm. La puissance de la cible est de 300W. Un essai antibactérien a été réalisé dans les mêmes conditions que précédemment, les échantillons étant, cependant, placés dans un incubateur humide, à 37°C, pendant 24 heures. Alors que 3548133 UFC sont dénombrées sur la lame de verre nue, aucune UFC n'a été dénombrée sur la lame de verre comportant le revêtement. Le revêtement a donc une action bactéricide totale.

Un revêtement selon l'invention peut, par exemple, être utilisé pour recouvrir un objet de joaillerie ou bien dans un dispositif antibactérien ou dans un dispositif de connexion.

## Revendications

1. Revêtement en matériau à base d'argent comportant un empilement d'une couche principale (1) et d'un film mince oxydé (2), **caractérisé en ce que** le film mince oxydé (2) a une épaisseur comprise entre 10nm et 1µm et **en ce qu'**il présente un gradient de concentration en argent décroissant depuis l'interface (3) entre le film mince (2) et la couche principale (1) jusqu'à la surface libre (2a) du film mince (2).

2. Revêtement selon la revendication 1, **caractérisé en ce que** le film mince oxydé (2) présente un gradient de concentration en oxygène croissant depuis l'interface (3) entre le film mince (2) et la couche principale (1) jusqu'à la surface libre (2a) du film mince (2).

3. Revêtement selon l'une des revendications 1 et 2, **caractérisé en ce que** le matériau à base d'argent est un alliage à base d'argent comportant au moins un élément d'addition oxydable.

4. Revêtement selon la revendication 3, **caractérisé en ce que** l'élément d'addition oxydable est choisi parmi l'étain, l'indium, le zinc, le germanium, l'aluminium, le magnésium, le manganèse et le titane.

5. Revêtement selon l'une des revendications 3 et 4, **caractérisé en ce que** le film mince (2) présente un gradient de concentration en élément d'addition croissant depuis l'interface (3) entre le film mince (2) et la couche principale (1) jusqu'à la surface libre (2a) du film mince (2).

6. Revêtement selon l'une quelconque des revendications 1 à 3, **caractérisé en ce que** le film mince oxydé (2) a une épaisseur comprise entre 100nm et 1µm.

7. Procédé de dépôt d'un revêtement selon l'une quelconque des revendications 1 à 6 sur un support, **caractérisé en ce qu'**il comporte au moins deux étapes successives de dépôt physique en phase vapeur, respectivement de la couche principale (1) et du film mince oxydé (2).

8. Procédé selon la revendication 7, **caractérisé en ce que** les étapes de dépôt sont des étapes de dépôt par pulvérisation cathodique magnétron.

9. Procédé selon la revendication 8, **caractérisé en ce que** le support est soumis à un premier potentiel de polarisation constant et négatif, pendant l'étape de dépôt de la couche principale (1) et à un second potentiel de polarisation constant, négatif et inférieur au premier potentiel, pendant l'étape de dépôt du film mince oxydé (2).

10. Procédé selon l'une des revendications 8 à 9, **caractérisé en ce que** de l'oxygène est introduit pendant l'étape de dépôt du film mince oxydé (2).

11. Utilisation d'un revêtement selon l'une quelconque des revendications 1 à 6 sur un objet de joaillerie, dans un dispositif antibactérien ou dans un dispositif de connexion.

## Claims

1. Silver-base material coating comprising a stack of one main layer (1) and one oxidized thin film (2), **characterized in that** the oxidized thin film (2) has a thickness comprised between 10nm and 1µm and presents a decreasing silver concentration gradient from an interface (3) between the thin film (2) and the main layer (1) to a free surface (2a) of the thin film (2).

2. Coating according to claim 1, **characterized in that** the oxidized thin film (2) presents an increasing oxygen concentration gradient from the interface (3) between the thin film (2) and the main layer (1) to the free surface (2a) of the thin film (2).

3. Coating according to any one of claims 1 and 2, **characterized in that** the silver-base material is a silver-base alloy containing at least one oxidizable alloying element.

4. Coating according to claim 3, **characterized in that** the oxidizable alloying element is selected from the group consisting of tin, indium, zinc, germanium, aluminium, magnesium, manganese and titanium.

5. Coating according to any one of claims 3 and 4, **characterized in that** the thin film (2) presents an increasing alloying element concentration gradient from the interface (3) between the thin film (2) and the main layer (1) to the free surface (2a) of the thin film (2).

6. Coating according to any one of claims 1 to 3, **characterized in that** the oxidized thin film (2) has a thickness comprised between 100nm and 1µm.

7. Method for depositing a coating according to any one of claims 1 to 6 on a support, **characterized in that** it comprises at least two successive physical vapor deposition steps, respectively of the main layer (1) and of the oxidized thin film (2).

8. Method according to claim 7, **characterized in that** the deposition steps are deposition steps by magnetron cathode sputtering.

9. Method according to claim 8, **characterized in that** the support is subjected to a constant negative first polarization potential, during the deposition step of the main layer (1) and to a constant negative second polarization potential that is lower than the first potential during the deposition step of the oxidized thin film (2).

10. Method according to any one of claims 8 and 9, **characterized in that** oxygen is input during the deposition step of the oxidized thin film (2).

11. Use of a coating according to any one of claims 1 to 6 on an item of jewellery, in an antibacterial device or in a connection device.

## Patentansprüche

1. Beschichtung aus einem Material auf Silberbasis, umfassend eine Aufschichtung aus einer Hauptschicht (1) und einem oxidierten dünnen Film (2), **dadurch gekennzeichnet, dass** der oxidierte dünne Film (2) eine Dicke im Bereich zwischen 10 nm und 1 µm aufweist und dass sie einen Silberkonzentrationsgradienten aufweist, der von der Grenzfläche (3) zwischen dem dünnen Film (2) und der Hauptschicht (1) bis zur freien Oberfläche (2a) des dünnen Films (2) abnehmend ist.

2. Beschichtung nach Anspruch 1, **dadurch gekennzeichnet, dass** der oxidierte dünne Film (2) einen Sauerstoffkonzentrationsgradienten aufweist, der von der Grenzfläche (3) zwischen dem dünnen Film (2) und der Hauptschicht (1) bis zur freien Oberfläche (2a) des dünnen Films (2) zunehmend ist.

3. Beschichtung nach einem der Ansprüche 1 und 2, **dadurch gekennzeichnet, dass** das Material auf Silberbasis eine Legierung auf Silberbasis ist, die wenigstens ein oxidierbares Zusatzelement umfasst.

4. Beschichtung nach Anspruch 3, **dadurch gekennzeichnet, dass** das oxidierbare Zusatzelement aus Zinn, Indium, Zink, Germanium, Aluminium, Magnesium, Mangan und Titan ausgewählt ist.

5. Beschichtung nach einem der Ansprüche 3 und 4, **dadurch gekennzeichnet, dass** der dünne Film (2) einen Zusatzelementkonzentrationsgradienten aufweist, der von der Grenzfläche (3) zwischen dem dünnen Film (2) und der Hauptschicht (1) bis zur freien Oberfläche (2a) des dünnen Films (2) zunehmend ist.

6. Beschichtung nach einem der Ansprüche 1 bis 3, **dadurch gekennzeichnet, dass** der oxidierte dünne Film (2) eine Dicke im Bereich zwischen 100 nm und 1 µm aufweist.

7. Verfahren zum Abscheiden einer Beschichtung nach einem der Ansprüche 1 bis 6 auf einem Träger, **dadurch gekennzeichnet, dass** es wenigstens zwei aufeinanderfolgende Schritte zur physikalischen Gasphasenabscheidung der Hauptschicht (1) bzw. des oxidierten dünnen Films (2) umfasst.

8. Verfahren nach Anspruch 7, **dadurch gekennzeichnet, dass** die Abscheidungsschritte Schritte zur Abscheidung mittels Magnetron-Kathodenzerstäubung sind.

9. Verfahren nach Anspruch 8, **dadurch gekennzeichnet, dass** der Träger während des Schrittes zur Abscheidung der Hauptschicht (1) einem ersten konstanten und negativen Polarisationspotential und während des Schrittes zur Abscheidung des oxidierten dünnen Films (2) einem zweiten Polarisationspotential, das konstant, negativ und geringer als das erste Potential ist, ausgesetzt wird.

10. Verfahren nach einem der Ansprüche 8 bis 9, **dadurch gekennzeichnet, dass** während des Schrittes zur Abscheidung des oxidierten dünnen Films (2) Sauerstoff eingeleitet wird.

11. Verwendung einer Beschichtung nach einem der Ansprüche 1 bis 6 auf einem Schmuckgegenstand, bei einer antibakteriellen Vorrichtung oder bei einer Verbindungsvorrichtung.
